# EUROPEAN PATENT SPECIFICATION

(11) **EP 2 587 651 B1**
(45) Date of publication and mention of the grant of the patent: **29.08.2018**
(21) Application number: 12007346.5
(22) Date of filing: 25.10.2012
(51) Int. Cl.: H02M 1/42, H05K 1/02, H02M 3/158

(54) **Switching regulator and power supply device including the same**
Schaltregler und Stromversorgungsvorrichtung damit
Régulateur de commutation et dispositif d'alimentation électrique le comprenant

(30) Priority: 27.10.2011 JP 2011236083
(43) Date of publication of application: 01.05.2013
(73) Proprietor: Sharp Kabushiki Kaisha, Osaka 545 (JP)
(72) Inventor: Kaijima, Yoshitsugu, Osaka, 545-8522 (JP); Sugawara, Yuri, Osaka, 545-8522 (JP)
(74) Representative: Müller Hoffmann & Partner

(56) References cited:
- JP-A- H1 075 079
- JP-A- 2001 359 280
- JP-A- 2011 172 431

## Description

This nonprovisional application is based on Japanese Patent Application No. 2011-236083 filed on October 27, 2011 with the Japan Patent Office, the entire contents of which are hereby incorporated by reference.

### BACKGROUND OF THE INVENTION

### Field of the Invention

The present invention relates to a switching regulator and a power supply device including the same. More specifically, the present invention relates to a switching regulator including an interleaved PFC (Power Factor Correction) circuit, and a power supply device including the same.

### Description of the Background Art

A power factor correction circuit of a switching regulator includes an inductor, a transistor, and a diode as main circuit components. For example, an IGBT (Insulated Gate Bipolar Transistor) is used as the transistor. Hereinafter, the power factor correction circuit is also referred to as a PFC (Power Factor Correction) circuit. A switching regulator of a high-load device with output of a few kW or more has the problem of suppressing size increase or the temperature of main circuit components due to increase in circuit current.

In order to solve this problem, switching regulators including interleaved PFC circuits are put into practice. An interleaved PFC circuit has two sets of main circuit components as described above. Those sets of main circuit components are alternately switched, so that the conducting current in each set of main circuit components is half the conventional one. Therefore, the configuration and operation as described above contributes to size reduction of the main circuit components. In addition, the productivity is improved because an inductor and the like that conventionally cannot be installed can be mounted on a circuit board. The improvement in productivity contributes to reduction in installation costs.

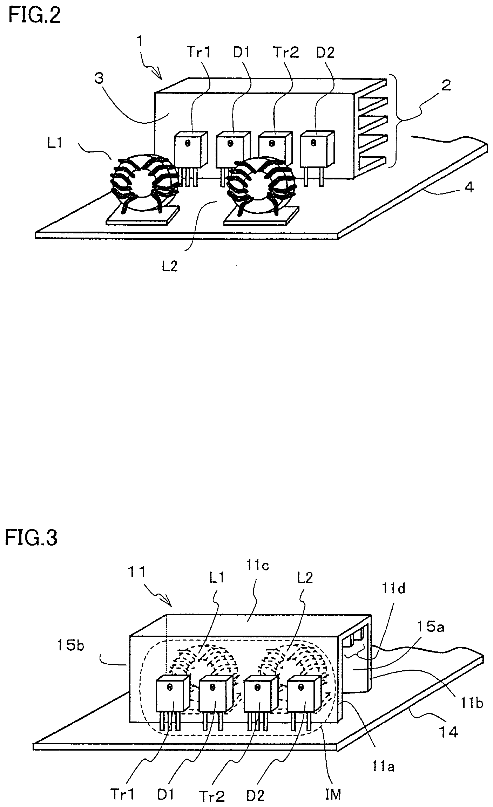

Referring to Fig. 2, a general arrangement of main circuit components included in an interleaved PFC circuit is described. An inductor L1, a transistor Tr1, and a diode D1 are a first set of main circuit components that constitute the interleaved PFC circuit. An inductor L2, a transistor Tr2, and a diode D2 are a second set of main circuit components. The two sets of main circuit components are mounted on a circuit board 4 together with a heat sink 1. Heat sink 1 is comprised of a circuit component installation portion 3 and a fin 2.

Of the two sets of main circuit components, transistor Tr1, diode D1, transistor Tr2, and diode D2 are attached to circuit component- installation portion 3 of heat sink 1. Inductor L1 and inductor L2 reduced in size can also be mounted on circuit board 4. Heat sink 1 is mounted with a surface of fin 2 on circuit board 4.

Japanese Patent Laying-Open No. 2008-306779 discloses a configuration in which a power MOSFET, a boost diode, and a choke coil that constitute an interleaved PFC circuit are installed on a circuit board. A heat dissipation plate is arranged on a back surface of the circuit board. The power MOSFET and the boost diode are attached to the heat dissipation plate. The heat dissipation plate is exposed in an opening formed in the circuit board.

Japanese Patent Laying-Open No. 2010-88153 discloses a configuration in which an input-side heat generating element (bridge diode) included an input-side circuit of a switching power supply circuit and an output-side heat generating element included in an output-side circuit are attached to a single heat dissipation plate. This configuration aims to reduce temperature variations between the input-side heat generating element and the output-side heat generating element due to operating temperatures.

Japanese Patent Laying-Open No. 2001-217577 discloses a configuration in which an electric component generating a large amount of heat is arranged outside a casing, and an electric component that is a source of electromagnetic noise, or an electric component susceptible to electromagnetic noise is arranged inside the casing. A plurality of heat dissipating fins are formed in the inside of the casing.

Japanese Patent Laying-Open No. 2003-125584 discloses a configuration in which a choke coil with a gap that forms a power factor correction circuit is shielded from a transformer with a heat sink. The heat sink is connected to a line providing a stable potential of a primary-side circuit of the transformer.

In the interleaved PFC circuit in Fig. 2, the number of circuit components installed on circuit component installation portion 3 of heat dissipation plate 1 increases by a factor of two when compared with a normal PFC circuit. The area of fin 2 attached to circuit component-installed portion 3 is increased, accordingly. As described above, heat sink 1 is mounted with fin 2 on circuit board 4. As a result, the area in which fin 2 is mounted in circuit board 4 is a dead space where a circuit component cannot be mounted. Therefore, the shape of circuit board 4 becomes larger.

The interleaved PFC circuit operates at a frequency twice a conventional PFC circuit. Therefore, the adverse effect of switching noise produced by two sets of main circuit components on other circuits or other equipment is a problem. In order to alleviate the effect of noise on other circuits by the switching regulator, two sets of main circuit components have to be mounted as closely as possible. However, such close mounting of circuit components reduces heat dissipation performance of each circuit component. In the worst case, temperature breakdown of the circuit components occurs.

### SUMMARY OF THE INVENTION

A switching regulator according to one aspect of the present invention includes: a circuit board; a heat sink having a first heat dissipation portion and a second heat dissipation portion, each in a rectangular shape, facing each other along a prescribed length at a prescribed distance from each other, and a third heat dissipation portion provided between the first heat dissipation portion and the second heat dissipation portion and extending along the prescribed distance to face the circuit board; and two sets of an inductor, a transistor, and a diode that constitute an interleaved power factor correction circuit. The heat sink is mounted on the circuit board such that the first heat dissipation portion and the second heat dissipation portion are in contact with the circuit board. The two sets of an inductor are mounted on the circuit board and are arranged in a spatial region formed of inner surfaces of the first heat dissipation portion, the second heat dissipation portion, and the third heat dissipation portion. The two sets of a transistor and a diode are mounted on the circuit board and attached to an outer surface of the first heat dissipation portion.

In the switching regulator according to one aspect of the present invention, preferably, at first and second end portions in a length direction of the heat sink, a first opening and a second opening are formed with the first heat dissipation portion, the second heat dissipation portion, the third heat dissipation portion, and the circuit board.

Preferably, the switching regulator according to one aspect of the present invention further includes a ground connection line connected to the heat sink, and the ground connection line supplies a ground potential to the heat sink.

In the switching regulator according to one aspect of the present invention, preferably, a heat dissipation hole is formed in the third heat dissipation portion.

In the switching regulator according to one aspect of the present invention, preferably, a transistor and a diode of a first set of the two sets are arranged to face an inductor of the first set with the first heat dissipation portion interposed, and a transistor and a diode of a second set of the two sets are arranged to face an inductor of the second set with the first heat dissipation portion interposed.

In the switching regulator according to one aspect of the present invention, preferably, an arrangement order of a transistor and a diode of the first set and an arrangement order of a transistor and a diode of the second set are the same in a direction in which the first heat dissipation portion extends.

A power supply device according to another aspect of the present invention includes the switching regulator as described above.

According to the present invention, a switching regulator having a heat sink can be provided in which the mounting area for electric components in a circuit board can be utilized effectively without impairing the heat dissipation capacity of the electric components mounted on the circuit board. Furthermore, according to the present invention, radiation noise produced by an inductor is shielded by the heat sink. Accordingly, the inductor and other electric components can be arranged adjacent to each other on the circuit board.

The foregoing and other objects, features, aspects and advantages of the present invention will become more apparent from the following detailed description of the present invention when taken in conjunction with the accompanying drawings.

### BRIEF DESCRIPTION OF THE DRAWINGS

Fig. 1 is a circuit diagram of a switching regulator including an interleaved PFC circuit according to an embodiment of the present invention.
Fig. 2 is a perspective view showing an arrangement of main circuit components of a switching regulator including an interleaved PFC circuit in a general example.
Fig. 3 is a perspective view showing an arrangement of main circuit components of a switching regulator including an interleaved PFC circuit according to an embodiment of the present invention.
Fig. 4 is a perspective view showing an arrangement of main circuit components of a switching regulator including an interleaved PFC circuit according to a first modified embodiment of the present invention.
Fig. 5 is a perspective view showing an arrangement of main circuit components of a switching regulator including an interleaved PFC circuit according to a second modified embodiment of the present invention.
Fig. 6 is a perspective view showing an arrangement of main circuit components of a switching regulator including an interleaved PFC circuit according to a third modified embodiment of the present invention.
Fig. 7 is a plan view showing an arrangement and connection of main circuit components of the switching regulator including the interleaved PFC circuit according to the embodiment and modifications thereof of the present invention.

### DESCRIPTION OF THE PREFERRED EMBODIMENTS

In the following, embodiments of the present invention will be described with reference to the figures. The scope of the present invention is not limited to the number, quantity, etc. mentioned in the description of the embodiments, if any, unless otherwise specified. In the figures of the embodiments, the same reference signs or reference numerals represent the same or corresponding parts. In the description of the embodiments, an overlapping description of the parts denoted with the same reference signs and the like may not be repeated.

### <Embodiment>

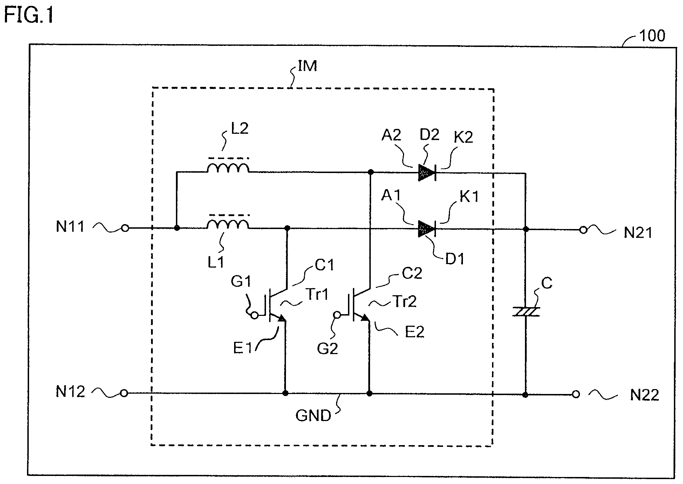

Referring to Fig. 1, a circuit configuration of a switching regulator including an interleaved PFC circuit according to an embodiment of the present invention will be described.

A power supply device 100 includes a switching regulator according to an embodiment of the present invention. The switching regulator is configured with a converter circuit including an interleaved PFC circuit. Input DC voltage is applied between an input node N11 and an input node N12. The input DC voltage is boosted and smoothed to be output to between an output node N21 and an output node N22. The interleaved PFC circuit includes an interleaved PFC main circuit IM. The interleaved PFC main circuit IM boosts the input DC voltage. The boosted voltage is smoothed by an electrolytic capacitor C. Input node N12 and output node N22 are both connected to GND line.

The interleaved PFC main circuit IM is configured with two sets of main circuit components. A first set of main circuit components includes an inductor L1, a diode D1, and a transistor Tr1. A second set of main circuit components includes an inductor L2, a diode D2, and a transistor Tr2.

Inductor L1 and diode D1 of the first set of main circuit components are connected in series between input node N11 and output node N21 in this order. Cathode K1 of diode D1 is connected to output node N21. Collector C1 of transistor Tr1 is connected to a line that connects anode A1 of diode D1 and one end of inductor L1. Emitter E1 of transistor Tr1 is connected to GND line. In this embodiment, transistor Tr1 is an IGBT. The potential of gate G1 of transistor Tr1 is controlled by a not-shown control circuit.

Inductor L2 and diode D2 of the second set of main circuit components are connected in series between input node N11 and output node N21 in this order. Cathode K2 of diode D2 is connected to output node N21. Collector C2 of transistor Tr2 is connected to a line that connects anode A2 of diode D2 and one end of inductor L2. Emitter E2 of transistor Tr2 is connected to GND line. In this embodiment, transistor Tr2 is an IGBT. The potential of gate G2 of transistor Tr2 is controlled by a not-shown control circuit.

Electrolytic capacitor C that smooths output voltage of the interleave main circuit IM is connected between output nodes N21 and N22. A circuit operation of the switching regulator including the interleaved PFC circuit is well known, and a description thereof is thus not repeated in this specification.

Referring to Fig. 3, a perspective view showing an arrangement of main circuit components of a switching regulator including an interleaved PFC circuit according to an embodiment of the present invention will be described.

A heat sink 11 is mounted on a circuit board 14. Heat sink 11 dissipates heat generated by the interleaved PFC main circuit IM into the air. Heat sink 11 has a first heat dissipation portion 11a and a second heat dissipation portion 11b. First heat dissipation portion 11a and second heat dissipation portion 11b each have a rectangular shape. Each of first heat dissipation portion 11a and second heat dissipation portion 11b is installed vertical to the surface of circuit board 14. First heat dissipation portion 11a and second heat dissipation portion 11b are arranged to face each other at a prescribed distance from each other. First heat dissipation portion 11a and second heat dissipation portion 11b each extend along a prescribed length. First heat dissipation portion 11a and second heat dissipation portion 11b are arranged such that the long side of the rectangle is parallel to the surface of circuit board 14 and the short side of the rectangle is vertical to the surface of circuit board 14. Heat sink 11 is mounted on circuit board 14 such that first heat dissipation portion 11a and second heat dissipation portion 11b are in contact with circuit board 14.

Heat sink 11 additionally has a third heat dissipation portion 11c. Third heat dissipation portion 11c is arranged between first heat dissipation portion 11a and second heat dissipation portion 11b. Third heat dissipation portion 11c faces circuit board 14 and is parallel to circuit board 14. Third heat dissipation portion 11c has a rectangular shape. Third heat dissipation portion 11c covers a space sandwiched between first heat dissipation portion 11a and second heat dissipation portion 11b from above. In other words, third heat dissipation portion 11c extends along the distance between first heat dissipation portion 11a and second heat dissipation portion 11b. A fin 11d is provided on a surface of third heat dissipation portion 11c that faces circuit board 14. In the following, the long side direction of first heat dissipation portion 11a, second heat dissipation portion 11b, and third heat dissipation portion 11c is defined as a length direction of heat sink 11. A cross section vertical to the length direction of heat sink 11 is shaped like a letter U.

First heat dissipation portion 11a, second heat dissipation portion 11b, third heat dissipation portion 11c, and circuit board 14 form a spatial region of heat sink 11 (hereinafter also simply referred to as "spatial region"). The spatial region has an opening 15a and an opening 15b at ends in the length direction of heat sink 11. In other words, the spatial region is not a space closed by first heat dissipation portion 11a, second heat dissipation portion 11b, third heat dissipation portion 11c, and circuit board 14. Opening 15a and opening 15b are provided to ensure breathability of the spatial region.

Transistor Tr1, diode D1, transistor Tr2, and diode D2 are all attached to an outer surface of first heat dissipation portion 11a and mounted on circuit board 14. The outer surface of first heat dissipation portion 11a means a surface that is opposite to the surface in contact with the spatial region. Inductor L1 and inductor L2 are arranged in the inside of the spatial region of heat sink 11 and are mounted on circuit board 14.

Heat generated by the two sets of the transistor and the diode attached to first heat dissipation portion 11a of heat sink 11 is dissipated into the air from first heat dissipation portion 11a, second heat dissipation portion 11b, and third heat dissipation portion 11c of heat sink 11. On the other hand, heat generated by inductor L1 and inductor L2 is dissipated into the outside air from opening 15a and opening 15b.

In circuit board 4 shown in Fig. 2, the area in which fin 2 is mounted is a dead space where a circuit component cannot be mounted. By contrast, heat sink 11 shown in Fig. 3 is mounted such that a portion defined by two sides in the thickness direction and two long sides of each of first heat dissipation portion 11a and second heat dissipation portion 11b is in contact with circuit board 14. The sum of the area of the portion of first heat dissipation portion 11a that is in contact with circuit board 14 and the area of the portion of second heat dissipation portion 11b that is in contact with circuit board 14 is smaller than the area of fin 2. As a result, even when heat sink 11 is mounted on circuit board 4, inductor L1 and inductor L2 can be mounted in a region of circuit board 14 that is present between first heat dissipation portion 11a and second heat dissipation portion 11b.

Fin 11d is provided on the surface of third heat dissipation portion 11c that faces circuit board 14, in accordance with the quantity of heat generated from the circuit components of the interleaved PFC main circuit IM. Accordingly, in addition to heat dissipation from first heat dissipation portion 11a, second heat dissipation portion 11b, and third heat dissipation portion 11c into the air, heat generated by inductor L1 and inductor L2 is dissipated from the spatial region to the outside through opening 15a and opening 15b of heat sink 11 from fin 11d. Therefore, heat dissipation is promoted.

The distance between first heat dissipation portion 11a and second heat dissipation portion 11b and the height of first heat dissipation portion 11a and second heat dissipation portion 11b are set appropriately in accordance with the size of inductor L1 and inductor L2 or the quantity of heat generated therefrom. The vertical length of fin 11d (in other words, the height of fin 11d) is selected in a range that does not affect the arrangement of inductor L1 and inductor L2 in the spatial region of heat sink 11. Fin 11d may not be provided depending on the quantity of heat generated by the interleaved PFC main circuit IM.

In the present embodiment, inductor L1 and inductor L2 are arranged in the inside of heat sink 11. Heat sink 11 is formed of a metal material. Thus, radiation noise produced from the inductors due to high frequency switching is shielded by heat sink 11. As a result, radiation noise to other circuit in the switching regulator or to external equipment can be reduced significantly.

### <First Modified Embodiment>

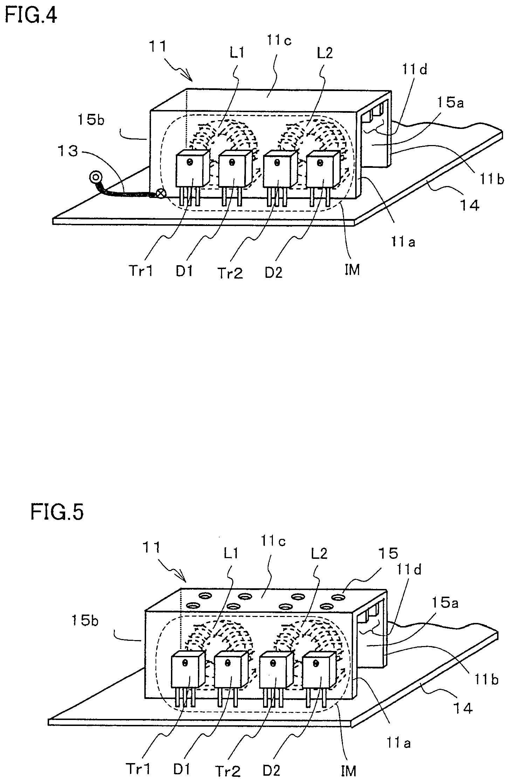

Referring to Fig. 4, a perspective view showing an arrangement of main circuit components of an interleaved PFC circuit of a switching regulator including an interleaved PFC circuit according to a first modified embodiment of the present invention will be described.

The configuration of the interleaved PFC circuit according to the first modified embodiment is the same as the embodiment shown in Fig. 1. In Fig. 4 and Fig. 3, the circuit components, the heat sink, etc. denoted with the same reference signs have the same configurations, and a description thereof will not be repeated.

In this first modification, a ground potential is supplied to heat sink 11. Therefore, a ground connection line 13 is connected to heat sink 11. Specifically, first heat dissipation portion 11a of heat sink 11 has a threaded hole to which one end of ground connection line 13 is fixed with a screw. Similarly, the other end of ground connection line 13 is electrically connected to a not-shown portion of the switching regulator that is supplied with GND potential, with a screw or by soldering. In this modification, one end of ground connection line 13 is connected to first heat dissipation portion 11a of heat sink 11. However, this point of connection may be selected appropriately from other portions of heat sink 11. The supply of ground potential (GND) to heat sink 11 further strengthens the shield effect of heat sink 11.

### <Second Modified Embodiment>

Referring to Fig. 5, a perspective view showing an arrangement of main circuit components of a switching regulator including an interleaved PFC circuit according to a second modified embodiment of the present invention will be described.

A perspective view showing an arrangement of main circuit components of a switching regulator including an interleaved PFC circuit according to the second modified embodiment of the present invention will now be described.

The configuration of the interleaved PFC circuit according to the second modified embodiment is the same as the embodiment shown in Fig. 1. In Fig. 5 and Fig. 3, the circuit components, the heat sink, etc. denoted with the same reference signs have the same configurations, and a description thereof will not be repeated.

In the second modification, a plurality of heat dissipation holes 15 are formed in third heat dissipation portion 11c of heat sink 11. The spatial region of heat sink 11 in which inductors L1 and L2 are arranged is provided with opening 15a and opening 15b to ensure breathability of the spatial region. When the quantity of heat generated from inductor L1 and inductor L2 is large, heat dissipation thereof from opening 15a and opening 15b may be insufficient.

Then, a plurality of heat dissipation holes 15 are arranged in third heat dissipation portion 11c of heat sink 11. Heat generated by inductor L1 and inductor L2 is dissipated to the outside of heat sink 11, thereby increasing the heat dissipation effect. The shape, number, and position of heat dissipation holes 15 arranged in heat sink 11 are determined by considering the required heat dissipation capacity and the shield effect of heat sink 11 against radiation noise altogether.

### <Third Modified Embodiment>

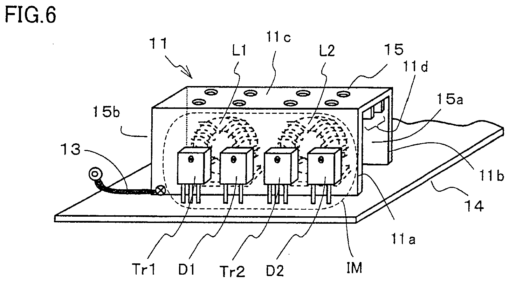

Referring to Fig. 6, a perspective view showing an arrangement of main circuit components of a switching regulator including an interleaved PFC circuit according to a third modified embodiment of the present invention will be described.

The configuration of the interleaved PFC circuit according to the third modified embodiment is the same as the embodiment shown in Fig. 1. In Fig. 6, and Fig. 3, Fig. 4, and Fig. 5, the circuit components, the heat sink, etc. denoted with the same reference signs have the same configurations, and a description thereof will not be repeated.

The switching regulator including the interleaved PFC circuit according to the third modification has ground connection line 13 of the first modification in Fig. 4. In addition, similarly to the second modification in Fig. 5, a plurality of heat dissipation holes 15 are formed in third heat dissipation portion 11c of heat sink 11. The supply of ground potential through ground connection line 13 can enhance the shield effect of heat sink 11. In addition, the heat dissipation effect of heat sink 11 is enhanced by heat dissipation holes 15.

### <Arrangement and Connection of Main Circuit Components According to Embodiment and Modifications Thereof>

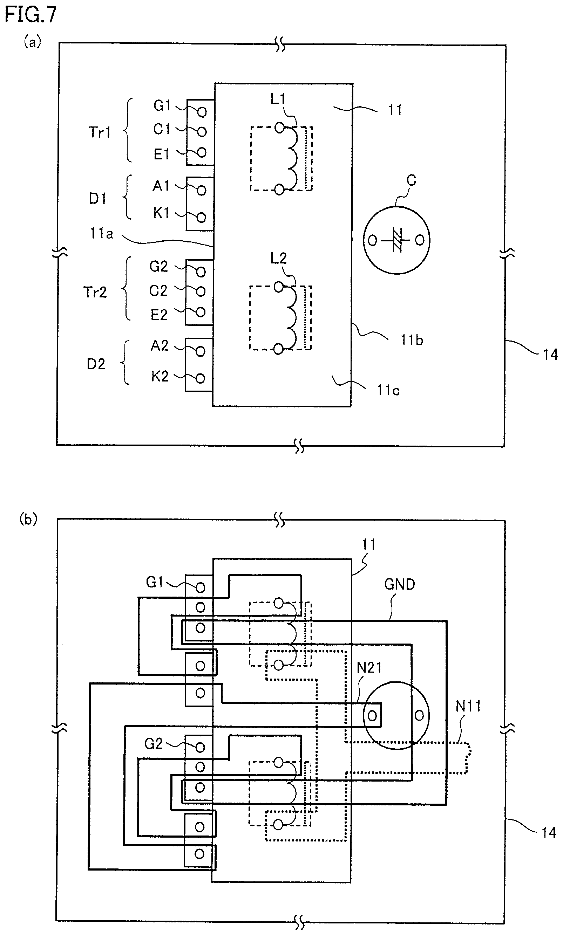

Referring to Fig. 7, a plan view showing an arrangement and connection of main circuit components of the switching regulator including the interleaved PFC circuit according to the embodiment and modifications thereof of the present invention will be described.

Fig. 7(a) is a plan view showing an arrangement of two inductors L1 and L2, two transistors Tr1 and Tr2, and two diodes D1 and D2 mounted on circuit board 14. Heat sink 11 and electrolytic capacitor C are additionally mounted on circuit board 14.

Transistor Tr1, diode D1, transistor Tr2, and diode D2 are attached to first heat dissipation portion 11a of heat sink 11. Inductor L1 is mounted on circuit board 14 in the spatial region of heat sink 11. Inductor L1 is arranged in proximity to transistor Tr1 and diode D1 with first heat dissipation portion 11a interposed. Inductor L2 is mounted on circuit board 14 in the spatial region of heat sink 11. Inductor L2 is arranged in proximity to transistor Tr2 and diode D2 with first heat dissipation portion 11a interposed. Electrolytic capacitor C is mounted on circuit board 14 in proximity to second heat dissipation portion 11b.

Fig. 7(b) shows wiring patterns formed on a front surface and a back surface of circuit board 14. The wiring pattern on the front surface is shown by a solid line, and the wiring pattern on the back surface is shown by a broken line. The front surface of circuit board 14 refers to a surface on which a circuit component is mounted. Inductor L1 and diode D1 are connected in series between input node N11 and output node N21. Collector C1 of transistor Tr1 is connected to a connection node between inductor L1 and diode D1. Transistor Tr1 controls current flowing through inductor L1 in response to a control signal applied to its gate G1.

Similarly, inductor L2 and diode D2 are connected in series between input node N11 and output node N21. Collector C2 of transistor Tr2 is connected to a connection node between inductor L2 and diode D2. Transistor Tr2 controls current flowing through inductor L2 in response to a control signal applied to its gate G2. Electrolytic capacitor C is connected between output node N21 and GND wiring (corresponding to output node N22 in Fig. 1) to smooth output voltage.

Heat sink 11 is mounted on circuit board 14 with the portions of first heat dissipation portion 11a and second heat dissipation portion 11b in contact with circuit board 14. First heat dissipation portion 11a and second heat dissipation portion 11b are arranged to face each other. As a result, inductor L1 and inductor L2 can be mounted in a region of circuit board 14 that is present between first heat dissipation portion 11a and second heat dissipation portion 11b. The mounting of heat sink 11 may reduce the area of circuit board 14 in which electric components are mounted. According to the embodiment and modifications thereof of the present invention, such reduction in the mounting area can be prevented to a large extent. By contrast, in the general switching regulator shown in Fig. 2, the heat sink is mounted with the surface of fin 2 on circuit board 4. This results in a dead space where a circuit component cannot be arranged.

As shown in Fig. 7(b), heat sink 11 shields radiation noise produced from inductor L1 and inductor L2. Inductor L1 and inductor L2 can be arranged adjacent to other main circuit components because radiation noise is shielded. As a result, two sets of main circuit components (L1/Tr1/D1 and L2/Tr2/D2) that constitute the interleaved PFC main circuit IM can be arranged with the shortest distance between each circuit component.

According to the embodiment and modifications thereof of the present invention, the distance between main circuit components can be reduced. This eliminates the restriction on the arrangement of the wiring pattern by heat sink 11. Therefore, the main circuit components can be connected with the shortest thick wiring. As a result, the value of parasitic inductor of the wiring pattern that connects the main circuit components is reduced, thereby reducing switching noise. The reduction of switching noise prevents withstand voltage breakdown of the main circuit component. As a result of reduction of the value of parasitic resistance of the wiring pattern, a temperature increase of the wiring pattern is suppressed. Accordingly, the lifetime of circuit board 14 is prolonged, and reliability of a solder connection portion is improved.

The foregoing effects can be achieved by reduction of the distance between main circuit components. In addition, in two sets of main circuit components that constitute the interleaved PFC main circuit IM, the wiring pattern of circuit board 14 for connecting the main circuit components can be formed in the same shape. In Fig. 7(b), the wiring pattern for connecting inductor L1, transistor Tr1, diode D1, and electrolytic capacitor C and the wiring pattern for connecting inductor L2, transistor Tr2, diode D2, and electrolytic capacitor C have the same shape.

Because of the same wiring pattern in two sets of main circuit components, an oscillation phenomenon of high frequency voltage between the two PFC circuits can be prevented during switching operation of the interleaved PFC circuit. Accordingly, stable interleave control is realized.

Although the present invention has been described and illustrated in detail, it is clearly understood that the same is by way of illustration and example only and is not to be taken by way of limitation, the scope of the present invention being interpreted by the terms of the appended claims.

## Claims

1. A switching regulator comprising:
a circuit board (14);
a heat sink (11) having a first heat dissipation portion (11a) and a second heat dissipation portion (11b), each in a rectangular shape, facing each other along a prescribed length at a prescribed distance from each other, and a third heat dissipation portion (11c) provided between said first heat dissipation portion (11a) and said second heat dissipation portion (11b) and provided to face said circuit board (14) along said prescribed distance; and
two sets of an inductor (L1, L2), a transistor (Tr1, Tr2), and a diode (D1, D2) that constitute an interleaved power factor correction circuit, wherein
said heat sink (11) is mounted on said circuit board (14) such that said first heat dissipation portion (11a) and said second heat dissipation portion (11b) are in contact with said circuit board (14),
said two sets of an inductor (L1, L2) are mounted on said circuit board (14) and are arranged in a spatial region formed of inner surfaces of said first heat dissipation portion (11a), said second heat dissipation portion (11b), and said third heat dissipation portion (11c), and
said two sets of a transistor (Tr1, Tr2) and a diode (D1, D2) are mounted on said circuit board (14) and attached to an outer surface of said first heat dissipation portion (11a).

2. The switching regulator according to claim 1, wherein at first and second end portions in a length direction of said heat sink (11), a first opening (15a) and a second opening (15b) are formed with said first heat dissipation portion (11a), said second heat dissipation portion (11b), said third heat dissipation portion (11c), and said circuit board (14).

3. The switching regulator according to claim 1 or claim 2, further comprising a ground connection line (13) connected to said heat sink (11),
wherein said ground connection line (13) supplies a ground potential to said heat sink (11).

4. The switching regulator according to any one of claims 1 to 3, wherein a heat dissipation hole (15) is formed in said third heat dissipation portion (11c).

5. The switching regulator according to any one of claims 1 to 4, wherein a transistor and a diode (Tr1, D1) of a first set of said two sets are arranged to face an inductor (L1) of said first set with said first heat dissipation portion (11a) interposed, and a transistor and a diode (Tr2, D2) of a second set of said two sets are arranged to face an inductor (L2) of said second set with said first heat dissipation portion (11a) interposed.

6. The switching regulator according to claim 5, an arrangement order of a transistor (Tr1) and a diode (D1) of said first set and an arrangement order of a transistor (Tr2) and a diode (D2) of said second set are the same in a direction in which said first heat dissipation portion (11a) extends.

7. A power supply device comprising the switching regulator of any one of claims 1 to 6.

## Patentansprüche

1. Schaltregler, umfassend:
eine Leiterplatte (14);
einen Kühlkörper (11) mit einem ersten Wärmedissipationsteil (11a) und einem zweiten Wärmedissipationsteil (11b), jeweils in einer rechteckigen Form, die entlang einer vorgeschriebenen Länge in einer vorgeschriebenen Distanz voneinander einander gegenüberliegen, und einem dritten Wärmedissipationsteil (11c), der zwischen dem ersten Wärmedissipationsteil (11a) und dem zweiten Wärmedissipationsteil (11b) vorgesehen ist und so vorgesehen ist, dass er der Leiterplatte (14) entlang der vorgeschriebenen Distanz gegenüberliegt; und
zwei Sätze eines Induktors (L1, L2), eines Transistors (Tr1, Tr2) und einer Diode (D1, D2), die eine verschränkte Leistungsfaktor-Korrekturschaltung bilden, wobei
der Kühlkörper (11) auf der Leiterplatte (14) so montiert ist, dass der erste Wärmedissipationsteil (11a) und der zweite Wärmedissipationsteil (11b) mit der Leiterplatte (14) in Kontakt stehen,
die beiden Sätze eines Induktors (L1, L2) auf der Leiterplatte (14) montiert und in einem räumlichen Bereich angeordnet sind, der von inneren Oberflächen des ersten Wärmedissipationsteils (11a), des zweiten Wärmedissipationsteils (11b) und des dritten Wärmedissipationsteils (11c) gebildet wird, und
die beiden Sätze eines Transistors (Tr1, Tr2) und einer Diode (D1, D2) auf der Leiterplatte (14) montiert und an einer äußeren Oberfläche des ersten Wärmedissipationsteils (11a) angebracht sind.

2. Schaltregler nach Anspruch 1, wobei an ersten und zweiten Endteilen in einer Längenrichtung des Kühlkörpers (11) eine erste Öffnung (15a) und eine zweite Öffnung (15b) mit dem ersten Wärmedissipationsteil (11a), dem zweiten Wärmedissipationsteil (11b), dem dritten Wärmedissipationsteil (11c) und der Leiterplatte (14) ausgebildet sind.

3. Schaltregler nach Anspruch 1 oder Anspruch 2, ferner umfassend eine Masseverbindungsleitung (13), die mit dem Kühlkörper (11) verbunden ist,
wobei die Masseverbindungsleitung (13) dem Kühlkörper (11) ein Massepotential bereitstellt.

4. Schaltregler nach einem der Ansprüche 1 bis 3, wobei ein Wärmedissipationsloch (15) in dem dritten Wärmedissipationsteil (11c) ausgebildet ist.

5. Schaltregler nach einem der Ansprüche 1 bis 4, wobei ein Transistor und eine Diode (Tr1, D1) eines ersten Satzes der beiden Sätze so angeordnet sind, dass sie einem Induktor (L1) des ersten Satzes gegenüberliegen, wobei der erste Wärmedissipationsteil (11a) dazwischen angeordnet ist, und ein Transistor und eine Diode (Tr2, D2) eines zweiten Satzes der beiden Sätze so angeordnet sind, dass sie einem Induktor (L2) des zweiten Satzes gegenüberliegen, wobei der erste Wärmedissipationsteil (11a) dazwischen angeordnet ist.

6. Schaltregler nach Anspruch 5, wobei eine Anordnungsreihenfolge eines Transistors (Tr1) und einer Diode (D1) des ersten Satzes und eine Anordnungsreihenfolge eines Transistors (Tr2) und einer Diode (D2) des zweiten Satzes in einer Richtung gleich sind, in der sich der erste Wärmedissipationsteil (11a) erstreckt.

7. Stromversorgungsvorrichtung, umfassend den Schaltregler nach einem der Ansprüche 1 bis 6.

## Revendications

1. Régulateur de commutation, comprenant :
un circuit imprimé (14) ;
un puits de chaleur (11) comportant une première partie de dissipation de chaleur (11a) et une deuxième partie de dissipation de chaleur (11b) qui ont une forme rectangulaire et qui se font face sur une longueur prescrite, à une distance prescrite l'une de l'autre, et une troisième partie de dissipation de chaleur (11c) qui est prévue entre la première partie de dissipation de chaleur (11a) et la deuxième partie de dissipation de chaleur (11b) et qui est prévue de manière à faire face au circuit imprimé (14) sur une distance prescrite ; et
deux ensembles composés d'un inducteur (L1, L2), d'un transistor (Tr1, Tr2) et d'une diode (D1, D2) qui constituent un circuit de correction de facteur de puissance imbriqué,
le puits de chaleur (11) étant monté sur le circuit imprimé (14) de telle sorte que la première partie de dissipation de chaleur (11a) et la deuxième partie de dissipation de chaleur (11b) sont en contact avec le circuit imprimé (14),
les deux ensembles composés d'un inducteur (L1, L2) étant montés sur le circuit imprimé (14) et étant disposés dans une zone spatiale formée de surfaces intérieures de la première partie de dissipation de chaleur (11a), de la deuxième partie de dissipation de chaleur (11b) et de la troisième partie de dissipation de chaleur (11c), et
les deux ensembles composés d'un transistor (Tr1, Tr2) et d'une diode (D1, D2) étant montés sur le circuit imprimé (14) et fixés sur une surface extérieure de la première partie de dissipation de chaleur (11a).

2. Régulateur de commutation selon la revendication 1, dans lequel sur les première et seconde parties d'extrémités, dans le sens de la longueur, du puits de chaleur (11), une première ouverture (15a) et une seconde ouverture (15b) sont formées avec la première partie de dissipation de chaleur (11a), la deuxième partie de dissipation de chaleur (11b) et la troisième partie de dissipation de chaleur (11c), et le circuit imprimé (14).

3. Régulateur de commutation selon la revendication 1 ou la revendication 2, comprenant également une ligne de connexion à la masse (13) qui est reliée au puits de chaleur (11),
la ligne de connexion à la masse (13) fournissant un potentiel de masse au puits de chaleur (11).

4. Régulateur de commutation selon l'une quelconque des revendications 1 à 3, dans lequel un orifice de dissipation de chaleur (15) est formé dans la troisième partie de dissipation de chaleur (11c).

5. Régulateur de commutation selon l'une quelconque des revendications 1 à 4, dans lequel un transistor et une diode (Tr1, D1) d'un premier des deux ensembles sont conçus pour faire face à un inducteur (L1) du premier ensemble, avec entre les deux la première partie de dissipation de chaleur (11a), et un transistor et une diode (Tr2, D2) d'un second des deux ensembles sont conçus pour faire face à un inducteur (L2) du second ensemble, avec entre les deux la seconde partie de dissipation de chaleur (11b).

6. Régulateur de commutation selon la revendication 5, dans lequel un ordre de disposition d'un transistor (Tr1) et d'une diode (D1) du premier ensemble et un ordre de disposition d'un transistor (Tr2) et d'une diode (D2) du second ensemble sont les mêmes dans une direction dans laquelle s'étend la première partie de dissipation de chaleur (lia).

7. Dispositif d'alimentation électrique comprenant le régulateur de commutation de l'une quelconque des revendications 1 à 6.
